(19) Europäisches Patentamt
European Patent Office
Office européen des brevets

(11) **EP 2 618 112 A1**

(12) **EUROPEAN PATENT APPLICATION**
published in accordance with Art. 153(4) EPC

(43) Date of publication:
**24.07.2013 Bulletin 2013/30**

(21) Application number: **11825234.5**

(22) Date of filing: **15.09.2011**

(51) Int Cl.:
*G01D 21/00* (2006.01)  *G01K 1/02* (2006.01)
*G08C 15/00* (2006.01)  *G08C 17/00* (2006.01)
*H04Q 9/00* (2006.01)

(86) International application number:
**PCT/JP2011/071099**

(87) International publication number:
**WO 2012/036234 (22.03.2012 Gazette 2012/12)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **16.09.2010  JP 2010208452**

(71) Applicants:
- **East Japan Railway Company
  Tokyo 151-8578 (JP)**
- **National University Corporation
  Hokkaido University
  Sapporo-shi, Hokkaido 060-0808 (JP)**

(72) Inventors:
- **WAKI Hiroshi
  Tokyo 151-8578 (JP)**

- **IGARASHI Hajime
  Sapporo-shi,
  Hokkaido 060-0808 (JP)**
- **WATANABE Kota
  Sapporo-shi,
  Hokkaido 060-0808 (JP)**
- **MAKIMURA Hidetoshi
  Sapporo-shi,
  Hokkaido 060-0808 (JP)**

(74) Representative: **Cabinet Laurent & Charras
Le Contemporain
50 Chemin de la Bruyère
69574 Dardilly Cedex France (FR)**

(54) **ENVIRONMENTAL INFORMATION MEASUREMENT DEVICE, ENVIRONMENTAL INFORMATION MEASUREMENT SYSTEM, AND ENVIRONMENTAL INFORMATION MEASUREMENT METHOD**

(57)   An environmental information measurement device includes: a power source unit; an environmental information detector; a timer; and a controller. The power source unit generates, from an electromagnetic wave received, a power source voltage to be supplied to a load. The load includes the environmental information detector, the timer, and the controller. The environmental information detector includes a detector including a circuit element having an impedance or an electrostatic capacitance that varies according to a physical amount detected under an environment at a measurement target point, and outputs a signal that varies according to a response characteristic of the detector. The timer measures a duration from the time when measurement is initiated to the time when a voltage of the signal becomes a predetermined detection voltage. The controller controls an operation of the environmental information detector.

FIG. 2

EP 2 618 112 A1

**Description**

TECHNICAL FIELD

The present invention relates to an environmental information measurement device, an environmental information measurement system, and an environmental information measurement method, which can measure environmental information at measurement target points.
Priority is claimed on Japanese Patent Application No. 2010-208452, filed September 16, 2010, the content of which is incorporated herein by reference.

BACKGROUND ART

It is occasionally necessary to measure environmental information at each of measurement target points that are widely dispersed. Environmental information to be measured includes the temperature, the humility, the atmosphere pressure, and the like. Those environmental information items are measured by an environmental information measurement device. Various measurement methods compatible with information to be measured are known. For example, in a case where the temperature is measured, a method using an infrared camera is known as a method of measuring the temperature of an object to be measured (see Non-Patent Document 1). Additionally, methods of making a measurement by contact with an object to be measured include a method using a thermosensitive label. For the method using a thermosensitive label, it is necessary to visually detect a display color. A measurer comes so close to a point as to confirm the thermosensitive label, and thus monitors the thremosensitive label. Those methods of measuring the temperature of an object to be measured are indirect measurement methods, but can be used as methods of measuring the temperature.
However, work by a measurer is necessary for the above methods. Therefore, the above methods are not suitable for purposes necessitating measurements at many measurement target points and at high measurement frequency, or measurements at points to which a measurer cannot come close. For this reason, a recording device, which contacts a temperature sensor with an object to be measured and thereby measures the temperature thereof, is disclosed (see Patent Document 1).

CITATION LIST

[Patent Document]

[Patent Document 1] Japanese Patent No. 3966779

[Non-Patent Document]

[Non-Patent Document 1] Hamazaki Photonics Corporation, "Near-infrared to infrared camera/ image measurement device" [online], July 2010, [searched on July 28, 2010], Internet <URL: http://jp.hamamatsu.com/products/camera/ 0001/index_ja.html>

DISCLOSURE OF INVENTION

Problems to be Solved by the Invention

There has been demand to manage the temperature of power transmission lines or power distribution lines in power systems (for example, to manage the temperature of connecting points of power transmission lines or power distribution lines), and manage the temperature of feeder cables for supplying the power to electric train lines (for example, to manage the temperature of connecting points of feeder cables). Measurement target points are widely dispersed, repetitive measurement is necessary, and high frequency of measurement is requested.
In the method using an infrared camera as disclosed in Non-Patent Document 1, measurement can be made while there is a distance between the measurement target point and the object to be measured. In a case where an infrared camera is installed at each measurement target point, the scale of the necessary facility becomes too large, thereby making the implementation unpractical. In a case where an infrared camera is moved to each measurement target point to make a measurement, continuous measurement cannot be made. Additionally, a measurer has to point an infrared camera to an object to be measured, in order to make a measurement, thereby making a measurement time at each measurement point longer.

In the method using thermosensitive labels, it is necessary for a measurer to come close to a point where the display color can be visually confirmed, and make a measurement. For this reason, for a measurement of the temperature of an electric cable in a charging state, applicability is occasionally limited for safety reasons.

Therefore, by use of the recording device disclosed in Patent Document 1, it is possible to decrease work of the measurer, thereby enabling a safe measurement.

However, there are some cases where measurement target points (temperature measurement target points) are further increased, or higher frequency of measurement is necessary. To satisfy such demands, communication of recorded measurement data requires a longer time. Additionally, the power consumption of the environmental information measurement device increases. Further, a large-scale device is required, thereby making the implementation impractical. The case where the temperature is measured is described above. However, similar problems arise in a case where environmental information at measurement target points is collected. In other words, in a case where there are many measurement target points (temperature measurement target points) to collect environmental information, such as the temperature, the humility, and the atmospheric pressure, or in a case where frequency of measurement is high, it is occasionally difficult to measure the temperature, thereby making the implementation impractical, as explained above. With respect to measurement of environmental information (humility, atmospheric pressure, and the like) other than the temperature, there is a similar problem that occasionally makes implementation unpractical.

The present invention has been made in view of the above situations. An object of the present invention is to provide an environmental information measurement device, an environmental information measurement system, and an environmental information measurement method, which can measure environmental information at measurement target points with low power consumption.

Means for Solving the Problems

The present invention has been made to solve the above problems. An environmental information measurement device according to one embodiment of the present invention includes: a power source unit; an environmental information detector; a timer; and a controller. The power source unit is configured to generate, from an electromagnetic wave received, a power source voltage to be supplied to a load. The load includes the environmental information detector, the timer, and the controller. The environmental information detector includes a detector including a circuit element having an impedance or an electrostatic capacitance that varies according to a physical amount detected under an environment at a measurement target point. The environmental information detector is configured to output a signal that varies according to a response characteristic of the detector. The timer measures a duration from the time when measurement is initiated to the time when a voltage of the signal becomes a predetermined detection voltage. The controller controls an operation of the environmental information detector.

The environmental information measurement device may further include a communication unit configured to transmit the environmental information according to a request.

The detector may include a capacitor. The controller may be configured to control, according to the power source voltage, charging of the capacitor and measurement of the duration by the timer.

The controller may be configured to initiate charging of the capacitor when the power source voltage becomes a predetermined charging initiation voltage.

The timer may be configured to measure a duration from the time when discharging of the capacitor is initiated to the time when the voltage of the signal is lowered to the detection voltage.

The environmental information detector may include: a first switch configured to block charging from the power source unit to the capacitor; and a second switch configured to block discharging of the capacitor. The controller may be configured to, when the capacitor is charged, control the first switch to be in a connected state to perform charging from the power source unit to the capacitor, and control the second switch to be in a disconnected state to terminate discharging of the capacitor. The controller may be configured to, when the capacitor is discharged, control the first switch to be in a disconnected state to terminate charging from the power source unit to the capacitor, and control the second switch to be in a connected state to perform discharging of the capacitor.

In the environmental information measurement device, the first switch may be in the connected state when the second switch is in the disconnected state, and the first switch may be in the disconnected state when the second switch is in the connected state.

The timer may be configured to, when charging of the capacitor is performed before discharging of the capacitor is initiated, measure a duration from the time when the voltage of the signal becomes the detection voltage to the time when the charging is terminated.

In the environmental information measurement device, the physical amount may include any one of a temperature, an atmospheric pressure, and a humidity. The environmental information detector may be configured to detect the physical amount from a circuit element included in the detector.

The environmental information detector may be configured to be thermally connected to an electric cable having a temperature to be measured.

An environmental information measurement system according to another embodiment of the present invention includes: the environmental information measurement device which is configured to transmit information measured based on the environmental information; and an environmental information collection device configured to collect the information transmitted.

An environmental information measurement method according to another embodiment of the present invention includes the following steps. A power source voltage to be supplied to a load is generated from the electromagnetic wave. A signal that varies according to a response characteristic of a circuit network is output. The network includes a circuit element having an impedance or an electrostatic capacitance that varies according to a physical amount detected under an environment at a measurement target point. A duration from the time when measurement is initiated to the time when a voltage of the signal becomes a predetermined detection voltage is measured. Environmental information according to the physical amount is generated. The step of outputting the signal, the step of measuring the duration, and the step of generating the environmental information are performed using the power source voltage.

Effects of the Invention

According to the present invention, it is possible to measure environmental information at measurement target points, using a circuit configuration with low power consumption.

BRIEF DESCRIPTION OF THE DRAWINGS

FIG. 1 is a diagram illustrating an example of an electric train line provided with an environmental information measurement device of the present invention.
FIG. 2 is a block diagram illustrating a configuration of the environmental information measurement device according to embodiments of the present invention.
FIG. 3A is a diagram illustrating an example of a configuration of an environmental information measurer 30 and a timer 40.
FIG. 3B is a graph illustrating operation of the environmental information measurer 30.
FIG. 4 is a flowchart illustrating operation of an environmental information measurement device.
FIG. 5A is a graph illustrating an example of the timing of detecting reception and the timing of charging a capacitor C.
FIG. 5B is a graph illustrating an example of the timing of detecting reception and the timing of charging the capacitor C.
FIG. 6 is a graph illustrating an example of the temperature property of a thermistor.
FIG. 7 is a diagram illustrating an example of a configuration of a voltage doubler rectifier circuit 21.
FIG. 8 is a diagram illustrating an example of a configuration of an environmental information measurement system.
FIG. 9A is a diagram illustrating an example of a configuration of an environmental information measurer 30A.
FIG. 9B is a timing chart illustrating operation of the environmental information measurer 30A.
FIG. 10A is a diagram illustrating an operational model of a detector 35 at the time of charging.
FIG. 10B is a diagram illustrating an operational model of the detector 35 at the time of discharging.
FIG. 11 is a graph illustrating a result of calculation per temperature.
FIG. 12 is a graph for comparing actual measured values and theoretical values of the temperatures measured by the environmental information measurer 30A.

BEST MODE FOR CARRYING OUT THE INVENTION

Hereinafter, embodiments of the present invention are explained with reference to the accompanying drawings.

(First Embodiment)

An environmental information measurement device according to a first embodiment of the present invention is a device to be mounted on a connecting point of feeder cables (such as crimping sleeves that connect electric cables by crimping). The environmental information measurement device includes an RFID tag as communication means. The environmental information collection device (tag reader) installed in a vehicle wirelessly communicates with the environmental information measurement device, thereby automatically collecting environmental information measured by the environmental information measurement device to manage the facility. Firstly, explanations are given with respect to a case where the environmental information measurement device measures the temperature. A method similar to the temperature measurement method is applicable to measure the temperature at a point where the environmental information measurement device is placed.

(Example of Installation of Environmental Information Measurement Device)

An environmental information measurement device 1 according to the present embodiment is used to manage the temperature of power transmission lines or power distribution lines in power systems (for example, to manage the temperature of connecting points of power transmission lines or power distribution lines), and manage the temperature of feeder cables for supplying the power to electric train lines (for example, to manage the temperature of connecting points of feeder cables connected via crimping sleeves).

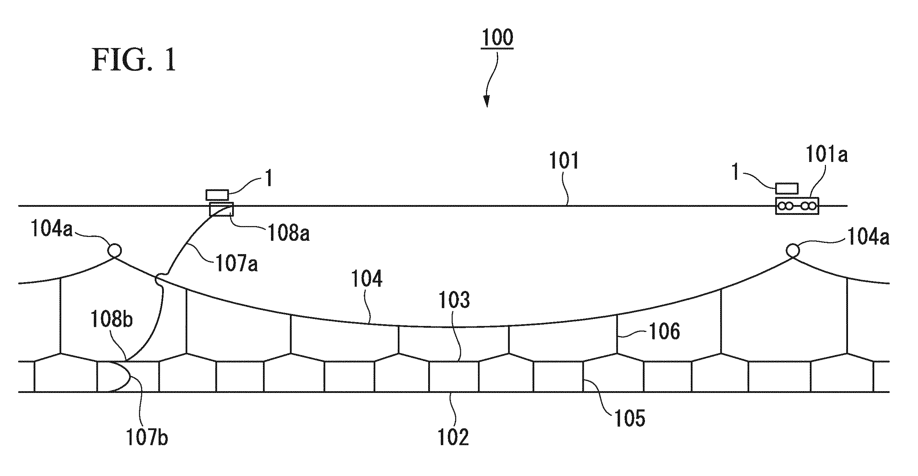

For example, FIG. 1 is a diagram illustrating an example of an electric train line on which the environmental information measurement device 1 of the present embodiment is installed. An electric train line 100 includes: a feeder cable 101; a trolley line 101; a supporting suspension wire 103; a suspension wire 104; a hanger connecting the trolley line 102 and the supporting suspension wire 103; and a feeder branch 107 connecting the feeder line 101 and the supporting feeder cable 103. The suspension wire 104 is fixed onto power poles (not shown) at supporting points 104a. One end of the feeder branch 107a is fixed to the feeder cable 101 via a clamp 108a. The other end of the feeder branch 107a is fixed to the supporting suspension line 103 via a clamp 108b. The environmental information measurement device 1 is attached onto the clamp 108a connecting the feeder cable 101 and the feeder branch 107a. Additionally, the environmental information measurement device 1 is attached to a connecting point of the feeder cables 101, such as a connecting point using a crimping sleeve (crimping sleeve 101a). By attachment in this manner, the environmental information measurement device 1 can be provided so as to be thermally connected to an electric cable targeted for a temperature measurement.

The clamp 108a connected to the above feeder branch 107a, and the connecting points of the feeder cables 101 (crimping sleeve 101a) have contact resistance, thereby generating large or small heat by current flowing always or discontinuously. Even if the temperature is not increased significantly due to that generated heat, if a high temperature is maintained for a long time, the electric resistance increases due to corrosion or fatigue. If this situation is not improved, generation of heat causes disconnection of the connecting points, thereby impeding power supply in some cases. For this reason, the environmental information measurement device 1 is installed at the feeder branches 107a or the connecting points of the feeder cables 101, so as to monitor an increase in temperature at the clamp 108a connected to the feeder branch 107a and the connecting points 101a of the feeder cables 101. Here, the environmental information measurement device 1 may be installed at only one of the clamp 108a connected to the feeder branch 107a, and the connecting point 101a of the feeder cable 101.

(Example of Configuration of Environmental Information Measurement Device)

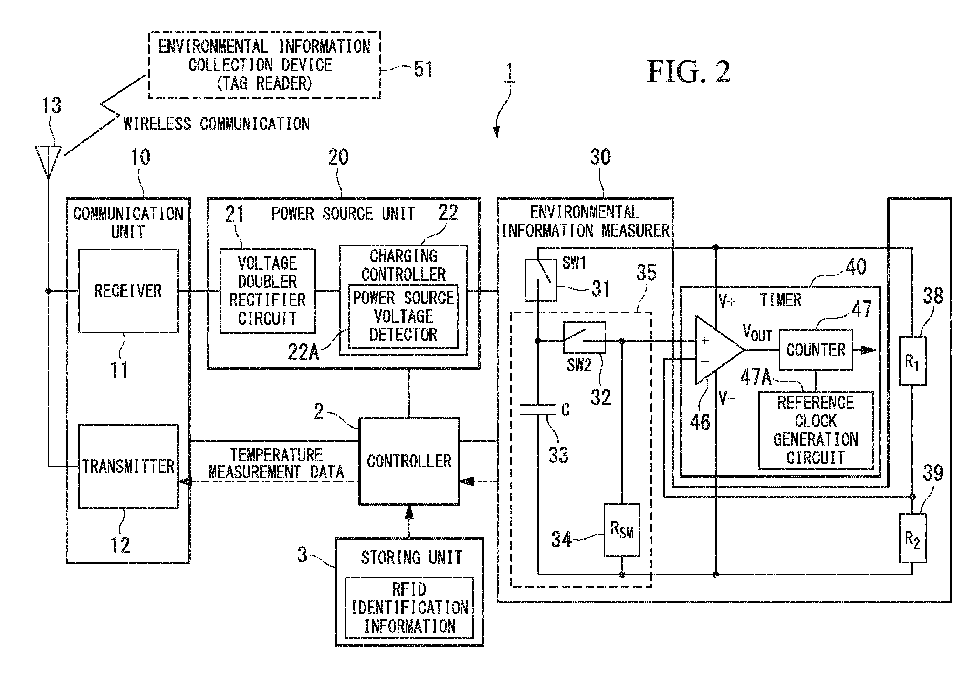

FIG. 2 is a block diagram illustrating a configuration of the environmental information measurement device 1 according to the embodiment of the present invention. The environmental information measurement device 1 shown in FIG. 2 includes: a communication unit 10 that communicates with an environmental information collection device (tag reader) 51 via an antenna 13; a power source unit 20 that generates power source (direct power source) from the power of electromagnetic waves received by the antenna 13; an environmental information measurer 30 that measures the temperature using a thermistor; a timer 40 that generates temperature measurement data based on a result of the detection by the environmental information measurer 30; a controller 2 that controls the entire environmental information measurement device 1; and a storing unit 3.

The environmental information measurement device 1 includes a communication unit, a CPU, a ROM, and the like, and other relating IC circuits (integrated circuits), and is implemented with use of a passive RFID (radio frequency identification) tag that wirelessly communicates with an external device via the antenna 13. The RFID tag has recently been implemented by a small one-chip IC, and thus is called an "IC tag."

The communication unit 10 includes a receiver 11 and a transmitter 12. The receiver 11 receives from an external device (environmental information collection device 51), via the antenna 13, electromagnetic waves modulated by a predetermined modulation scheme. Then, the communication unit 10 demodulates the received electromagnetic waves, thus receiving signals. Additionally, the transmitter 12 generates modulated waves based on the temperature measurement data measured by the environmental information measurer 30. Then, the transmitter 12 amplifies the modulated waves, and transmits the amplified modulated waves as wireless electromagnetic waves to the external device via the antenna 13. The antenna 13 is an antenna formed by applying a cupper hoil pattern on a surface of a printed circuit board of the RFID. The length of the antenna 13 is set to, for example, $\lambda/4$ of the wireless transmission frequency.

The controller 2 controls overall operation of each unit of the environmental information measurement device 1. For example, this controller 2 controls a measurement of the temperature by the environmental information measurer 30. Additionally, the controller 2 performs control for wirelessly transmitting, as signal waves, the temperature measurement data measured by the environmental information measurer 30. This environmental information measurement device 1 is appended with a unique identification number (sensor ID). This identification information is stored in the storing unit 3 as RFID identification information.

The power source unit 20 is a power source unit that uses the electromagnetic waves received from the tag reader (reception device) 51 via the antenna 13 as the energy source, and supplies the power to each unit of the RFID tag. This power source unit 20 includes a voltage doubler rectifier circuit 21 and a charging controller 22. The voltage doubler rectifier circuit 21 performs voltage doubler rectification on the electromagnetic waves received via the antenna 13 to generate a direct-current voltage, and increases the direct-current voltage to a predetermined voltage. Additionally, the charging controller 22 charges an element of the electrostatic capacitance of the capacitor C (33) in the environmental information measurer 30, using the direct-current voltage increased to the predetermined voltage. This charging controller 22 includes a power source voltage detector 22A that detects the amount of the power source voltage generated by the voltage doubler rectifier circuit 21.

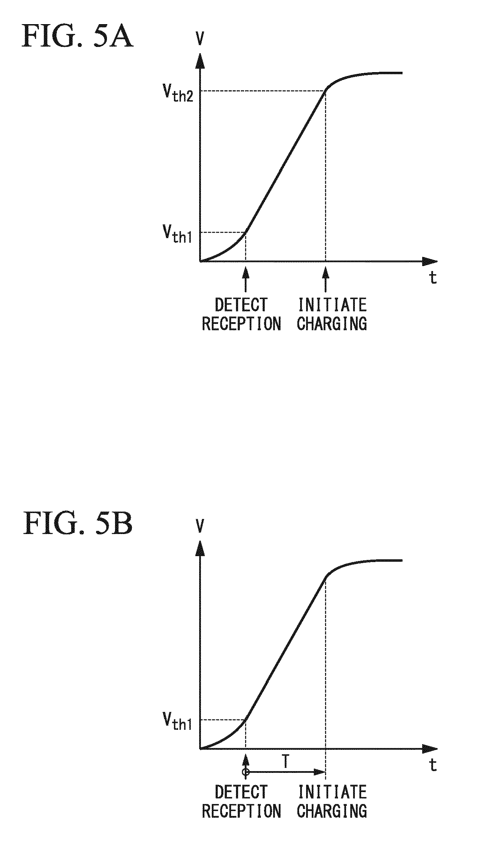

As shown in FIGS. 5A and 5B, this power source voltage detector 22A detects that an electromagnetic wave is received from the environmental information collection device (tag reader) 51, when the voltage of the power source (power source voltage) generated from the wireless electromagnetic waves exceeds a predetermined threshold voltage $V_{th1}$. Then, the power source voltage detector 22A notifies the controller 2 of information concerning the detection of this reception. Additionally, as shown in FIG. 5A, the power source voltage detector 22A notifies the controller 2 of this information when the power source voltage exceeds a predetermined threshold voltage $V_{th2}$ (charging initiation voltage). The controller 2 controls the charging controller 22 to initiate charging of the capacitor C (33) in the environmental information measurer 30, when the power source voltage detector 22A detects that the power source voltage exceeds the threshold voltage $V_{th2}$ (charging initiation voltage). Regarding the timing of initiating the charging of the capacitor C, as shown in FIG. 5B, the controller 2 measures a predetermined duration T using a timer after the power source voltage exceeds the threshold voltage $V_{th1}$, and then charging of the capacitor C (33) may be initiated when the predetermined duration T elapses. An example of a configuration of the voltage doubler rectifier circuit 21 will be explained later.

(Configurations and Operations of Environmental Information Measurer 30 and Timer 40)

Hereinafter, configurations and operations of the environmental information measurer 30 and the timer 40 are explained.

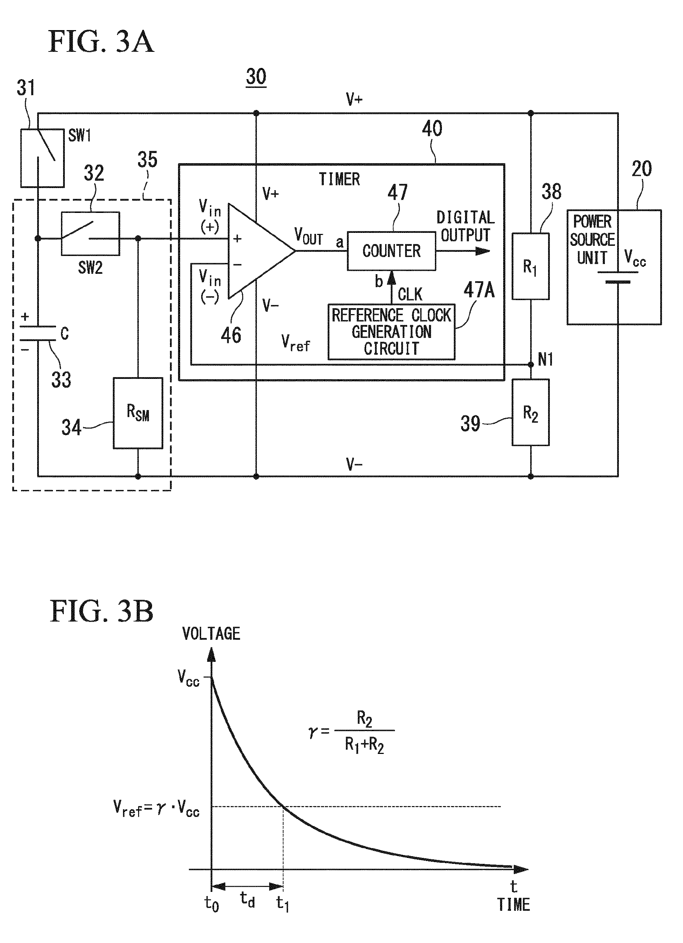

FIG. 3A is a diagram illustrating an example of the configurations of the environmental information measurer 30 and the timer 40. As shown in FIG. 3A, the environmental information measurer 30 includes: switches SW1 (31) and SW2 (32); a capacitor C (33) to be charged with the power source (voltage $V_{cc}$) generated by the power source unit 20; a thermistor $R_{SM}$ (34) that is a temperature sensor having a resistance value varying according to the temperature; and resistors $R_1$ (38) and $R_2$ (39) that form the voltage divider for the power source voltage.

A circuit network including those capacitor C (33) and thermistor $R_{SM}$ (34) constitutes a detector 35.

Additionally, the switches SW1 (31) and SW2 (32) are actually semiconductor switches including a MOS transistor, an analog switch, or the like.

Further, the timer 40 includes: a comparator 46; a counter 47; and a reference clock generation circuit 47A. The comparator 46, the counter 47, and the reference clock generation circuit 47A measure (time) a duration from the time when discharging of the capacitor C (33) is initiated to the time when the charged voltage of the capacitor C (33) becomes a reference voltage $V_{ref}$.

In FIG. 3A, one end of the switch SW1 (31) is connected to a positive terminal of the capacitor C (33), and the other end thereof is connected to a positive terminal of the power source unit (voltage $V_{cc}$) via a power source line V+. One end of the switch SW2 (32) is connected to a positive terminal of the capacitor C (33), and the other end of thereof is connected to a non-inverting input terminal $V_{in}(+)$ of the comparator 46. Additionally, one end of the thermistor $R_{SM}$ (34) that serves as a temperature sensor is connected to the non-inverting input terminal $V_{in}(+)$ of the comparator 46, and the other end thereof is connected to a negative terminal of the power source unit 20 via a power source line V-. Further, a negative terminal of the capacitor C (33) is connected to the negative terminal of the power source unit 20 via the power source line V-.

One end of the resistor $R_1$ (38) is connected to the power source line V+, and the other end thereof is connected to one end of the resistor $R_2$ (39) via a node N1. The other end of the resistor $R_2$ (39) is connected to the power source line V-. Accordingly, the node N1 is a point at which the output voltage $V_{cc}$ of the power source unit 20 is voltage-divided. Additionally, this node N1 is connected to the non-inverting input terminal $V_{in}(-)$ of the comparator 46. Further, the output side of the comparator 46 is connected to a timer control terminal a of the counter 47. Moreover, a clock input terminal b of the counter 47 is connected to an output terminal of the reference clock generation circuit 47A. The reference clock generation circuit 47A inputs a reference clock CLK to the clock input terminal b.

The above thermistor $R_{SM}$ (34) is placed so as to be exposed to the attachment surface side of the environmental information measurement device 1 (surface of the attachment onto the temperature measurement target point). Then, the environmental information measurement device 1 is fixed onto the temperature measurement target point (such as a surface of the crimping sleeve 101a that connects the feeder cable 101 and the feeder) by adhesion via a silicon rubber compound (silicon rubber compound for enhancing electrical insulation and thermal conductivity), silicon grease, or the like. Here, the thermistor $R_{SM}$ (34) may be configured to be detachable from the main body of the environmental information measurement device 1, so that the thermistor $R_{SM}$ alone can be fixed onto the temperature monitoring target point.

FIG. 3B is a graph illustrating operation of the environmental information measurer 30. Hereinafter, the operation of the environmental information measurer 30 is explained with reference to FIGS. 3A and 3B. Regarding explanations of these drawings, it is assumed that the power source voltage $V_{cc}$ (charging initiation voltage) is in a state of being able to be supplied from the power source unit 20 to the environmental information measurer 30.

In this state, under control of the controller 2, the switch SW1 (31) is closed, and the switch SW2 (32) is opened, thereby charging the capacitor C (33) to the power source voltage $V_{cc}$ (a state at the time to shown in FIG. 3B). Then, under control of the controller 2, the switch SW1 (31) is opened, and the switch SW2 (32) is closed, thereby discharging the electric charge stored in the capacitor C (33) via the thermistor $R_{SM}$ (34). The charged voltage of the capacitor C (33) gradually decreases, and becomes identical to the reference voltage $V_{ref}$ at the time $t_1$. Then, when the charged voltage of the capacitor C (33) becomes lower than the reference voltage $V_{ref}$, the output signal $V_{out}$ of the comparator 46 inverts from an H state (voltage corresponding to voltage V+ of the power source supply to the comparator) to an L state (voltage corresponding to the voltage V- of the power source supply to the comparator).

Under control of the controller 2, the counter 47 counts the reference clock CLK output from the reference clock generation circuit 47A for a duration $t_d$ from the time when discharging of the capacitor C (33) is initiated to the time when the output signal of the comparator 46 transits from the H state to the L state. Thus, the environmental information measurer 30 counts the duration (the number of reference clocks) from the discharging of the capacitor C (33) is initiated to the time when the comparator 46 operates, thereby converting the temperature into time to make a measurement.

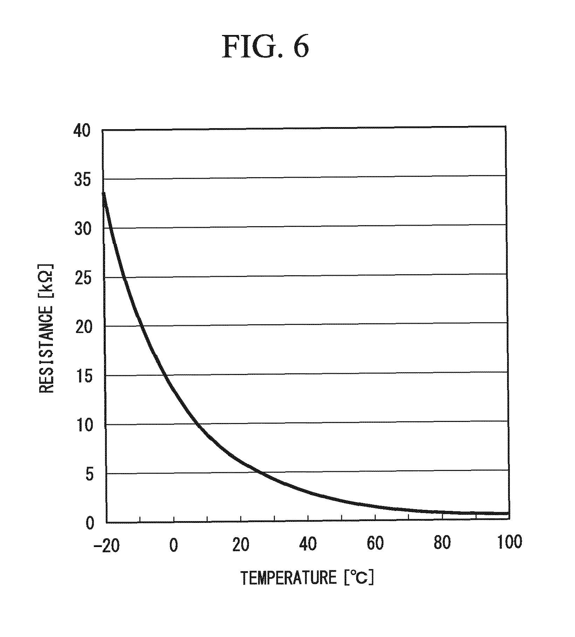

For example, a resistance value of the thermistor $R_{SM}$ (34) decreases as the temperature increases, as shown in FIG. 6. Accordingly, as the temperature increases, the discharging speed of the electric charge stored in the capacitor C (33) increases, and thus the number of reference clocks counted by the counter 47 decreases. Thus, it is possible to measure the temperature of the thermistor $R_{SM}$ (34) (i.e., temperature at the temperature measurement target point) based on the number of reference clocks counted by the counter 47.

The reason why the circuit configuration of the environmental information measurer 30 shown in FIG. 3A is employed, the formula shown in FIG. 3B, and the like will be explained later.

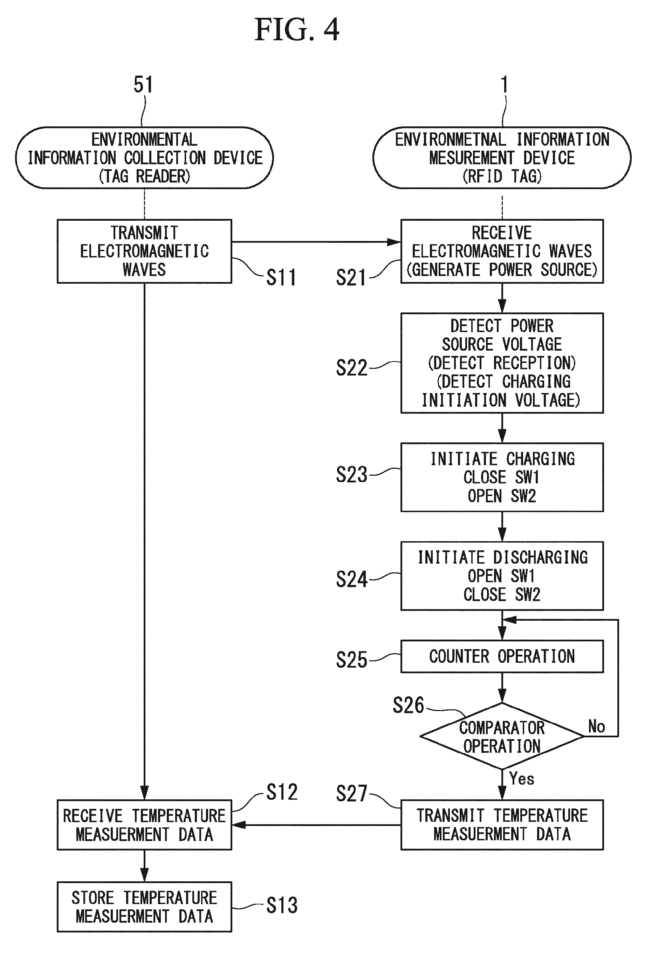

FIG. 4 is a flowchart illustrating the entire operation of the environmental information measurement device 1. This example shows a case where the environmental information collection device (tag reader) 51 gradually comes close to the environmental information measurement device (RFID tag) 1 from the distance, and the environmental information collection device (tag reader) 51 receives temperature data from the environmental information measurement device 1 in the state where the environmental information collection device (tag reader) 51 is close enough to communicate with the environmental information measurement device (RFID tag) 1. Hereinafter, the operation of the environmental information measurement device 1 is explained with reference to FIG. 4.

The tag reader (environmental information collection device) 51 comes close to the environmental information measurement device (RFID tag) 1 while transmitting to the environmental information measurement device (RFID tag) 1, by an electromagnetic wave, a signal that requests for transmission of temperature information (step S11). The environmental information measurement device 1 receives the electromagnetic wave transmitted from the environmental information collection device 51 (step S21). Then, the power source unit 20 of the environmental information measurement device 1 generates a power source (direct-current power source) from the power obtained from the received electromagnetic wave. The voltage of that power source increases as the environmental information collection device 51 comes closer to the environmental information measurement device 1.

Then, the power source voltage detector 22A of the power source unit 20 detects the voltage of the generated power source (step S22). When it is detected that the power source voltage becomes equal to or higher than the predetermined threshold voltage $V_{th1}$ as shown in FIG. 5A, the power source unit 20 notifies the controller 2 of that the electromagnetic wave from the environmental information collection device 51 has been received and detected. Then, when the power source voltage increases and it is detected that the power source voltage becomes equal to or higher than the predetermined threshold $V_{th2}$ as shown in FIG. 5A (i.e., it is detected that the power source voltage becomes the charging initiation voltage), the power source unit 20 notifies the controller 2 of this detection.

When it is detected that the power source voltage becomes equal to or higher than the predetermined threshold voltage $V_{th2}$, the controller 2 closes the switch SW1 (31) in the environmental information measurer 30 and opens the switch SW2 (32) therein, thereby charging the capacitor C (33) using the power source voltage (step S23). Then, after a predetermined time has elapsed, that is, after charging of the capacitor C (33) is completed, the controller 2 opens the switch SW1 (31) in the environmental information measurer 30 and closes the switch SW2 (32) therein, thereby initiating discharging of the electric charge stored in the capacitor C (33) via the thermistor $R_{SM}$ (34) (step S24).

The controller 2 initiates discharging of the capacitor C (33) and activates the counter 47, thereby controlling the counter 47 to initiate counting the reference clock CLK (step S25). Then, while the capacitor C (33) is discharged, the controller 2 controls the comparator 46 to detect whether or not the voltage of the capacitor C (33) becomes equal to or lower than the reference voltage $V_{ref}$ (step S26). When it is detected that the voltage of the capacitor C (33) becomes lower than the reference voltage $V_{ref}$ (step S26: YES), the controller 2 controls the counter 47 to terminate the operation of the counting and transmits the data that is the value counted by the counter 47 to the environmental information collection device 51, as the temperature measurement data converted into a time (step S27). The environmental information collection device 51 receives the temperature measurement data from the environmental information measurement device 1 (step S12), stores the temperature data, and displays the temperature data on a display device or the like. By the above procedure, the environmental information measurement device 1 measures the temperature at the temperature measurement target point, and the environmental information collection device (tag reader) 51 can automatically collect the temperature measurement data measured by the environmental information measurement device 1. Therefore, even in a case where there are many temperature measurement target points, is it possible to easily and automatically collect temperature measurement data.

(Circuit Configuration of Temperature Measurer)

As explained above, the environmental information measurer 30 includes: the switches SW1 (31) and SW2 (32); the capacitor C (33); the thermistor $R_{SM}$ (34); and the resistors $R_1$ (38) and $R_2$ (39). The timer 40 includes: the comparator 46; the counter 47; and the reference clock generation circuit 47A. Thus, in the environmental information measurement device 1, the environmental information measurer 30 and the timer 40 are combined so that the temperature is converted into a time to make a measurement. The reason why such a circuit configuration is employed is that the environmental information measurement device 1 uses an RFID tag, and that RFID tag generates a power source based on electromagnetic waves received from a tag reader, thereby requiring a circuit with low power consumption. Hereinafter, this respect is explained.

There are some kinds of temperature sensors. If grouped according to operational principles, the temperature sensors include a thermocouple, a p-n junction diode, an infrared sensor, a thermistor, and the like. Among these sensors, the thermocouple is a sensor that uses current which flows when different types of metals are connected in a ring shape, and the temperatures of two contact points differ from each other. In this method, it is necessary to set one of the contact points to a measurement target and the other of the contact points to a place where the temperature is known. Therefore, this is not suitable in use to the RFID tag to which the present invention is directed.

The method of using the p-n junction diode uses the temperature dependence of the forward voltage drop of a diode. Silicon diodes included in an IC and an LSI can be used as temperature sensors. However, the sensitivity of those temperature sensors is substantially 1 mV/°C. Additionally, it is necessary to make the current that flows in the diode constant. Thus, management of the sensors is difficult. Further, the infrared sensor detects the amount of infrared ray emitted by an object, but is not suitable to be built in the RFID tag in view of the size and the power consumption.

On the other hand, the thermistor is a resistor using a material whose resistivity varies according to the temperature. An NTC (negative temperature coefficient) indicating a negative value of a variation coefficient of the resistivity with respect to the temperature have relatively high linearity, compared to the other coefficient indicating a positive value of the variation coefficient. Additionally, a high-precision thermistor can be manufactured, and therefore it is possible to measure the temperature with desired precision. Further, it is easy to manufacture a thermistor with the resistance value up to substantially 100 kΩ. Here, an example of the temperature property of the thermistor is shown in FIG. 3B, as an example of a temperature sensor with low power consumption. The power consumption of this thermistor is 12.5 μW (2.5 Vx5 μA), which is low power consumption.

Information obtained from temperature sensors including a thermistor is an analog value. Therefore, it is necessary to convert the analog value into a digital signal. For this reason, an analog-to-digital (AD) converter is used generally. There are many AD converters including a comparator that compares the voltages of two input signals and outputs a digital signal indicating a result of the comparison. However, the power consumption of an AD converter is generally too large to be used for an RFID tag, and the power consumption of even an AD converter with low power consumption is substantially several hundreds of μW. For this reason, it is difficult to include an AD converter in the RFID tag.

The signal output from the AD converter is a serial or parallel digital signal. Considering information required for the present embodiment, it is not always necessary to convert the analog signal into a digital signal. Therefore, an RC discharging circuit, a comparator, and a counter are used in order to convert the temperature into time, thereby obtaining temperature measurement data as the digital amount. In other words, the circuit configuration shown in FIG. 3A is employed.

As shown in FIG. 3B, at first, the switch SW1 (31) is set to be closed, the switch SW2 (32) is set to be open, thus charging the power source voltage $V_{cc}$ of the capacitor C (33). Then, when a measurement is initiated, the controller 2 controls the switch SW1 (31) to be opened and the switch SW2 (32) to be closed, thereby discharging the electric charge stored in the capacitor C (33) via the thermistor $R_{SM}$ (34). At this time, time required for the voltage of the capacitor C (33) to become lower than the reference voltage $V_{ref}$. At this time, if the power source voltage $V_{cc}$ is voltage-divided using the resistor $R_1$ (38) and $R_2$ (39) to generate the reference voltage $V_{ref}$, the discharging duration from the time when the discharging is initiated to the time when the voltage of the capacitor becomes the reference voltage $V_{ref}$ does not depend on the amount of the power source voltage. In other words, the discharging voltage $V_{in}(t)$ is expressed as Formula (1).

[Formula 1]

$$V_{in}(t) = V_{cc} \exp\left(-\frac{t}{R_{SM}C}\right) \tag{1}$$

The discharging voltage $V_{in}(t)$ shown in Formula (1) is indicated as a linear response function using the power source voltage $V_{cc}$ and the time constant ($R_{SM}C$). Additionally, the reference voltage $V_{ref}$ can be expressed as Formula (2) using the resistors $R_1$ (38) and $R_2$ (39).

[Formula 2]

$$V_{ref} = \gamma \cdot V_{cc} = \frac{R_2}{R_1 + R_2} \cdot V_{cc} \tag{2}$$

In Formula (2), y denotes a partial pressure ratio.

When the duration $t_d$ required for the discharging voltage $V_{in}(t)$ to become equal to or lower than the reference voltage $V_{ref}$ is calculated from Formula (2), the duration $t_d$ can be expressed as Formula (3).

[Formula 3]

$$t_d = \ln(\gamma)R_{SM}C \tag{3}$$

Thus, the duration $t_d$ can be expressed using the resistance value $R_{SM}$ of the thermistor, the electrostatic capacitance C of the capacitor, and the partial pressure ratio. Thus, it can be understood that the duration $t_d$ does not depend on the power source voltage. Therefore, using this circuit, it is possible to convert the measured temperature into time. Additionally, it is possible to use the signal output from this circuit directly as a response signal from the RFID tag (environmental information measurement device 1) to the tag reader (environmental information collection device 51). For example, a measurement of the temperature is initiated at the same time that the RFID tag initiates transmission of data back to the tag reader. In other words, the controller 2 changes the states of the switches SW1 (31) and SW2 (32), thereby initiating discharging of the capacitor C (33). Then, for example, the RFID tag transmits "0" until the discharging voltage $V_{in}(t)$ becomes the reference voltage $V_{ref}$ and thereby the output of the comparator is inverted. After the output of the comparator is inverted, the RFID tag transmits "1". The tag reader demodulates the data received from the RFID tag, and counts the number of "0" included in the data, thereby making it possible to calculate the temperature measured by the RFID tag.

Additionally, this environmental information measurer 30 operates with low power source voltage and uses an analog switch element with low power consumption. As an analog switch element which is currently available, for example, there is an analog switch element with the specification such that "operational power source voltage range: 1.8 V to 5.5 V", "power consumption: 1 $\mu$W", and "operational frequency band: 250 MHz". If a several-M$\Omega$ resistor is used for the above analog switch and the resistors $R_1$ (38) and $R_2$ (39), the power consumption of this circuit can be reduced to substantially 1 $\mu$W.

Thus, a simple circuit configuration with low power consumption is required for the environmental information measurement device 1 of the present embodiment to perform communication using the RFID tag. For this reason, the environmental information measurer 30 has the circuit configuration as shown in FIG. 3.

In the present embodiment, the capacitor C (33) has been previously charged, and a change in the voltage is detected while the capacitor C (33) is discharged. The power source of the environmental information measurement device 1 is supplied by the RFID tag from the power source unit 20 that generates the power based on the received electromagnetic waves. For this reason, differing from the general power source, this power source is an unstable power source that varies according to the strength of the electric field of the received electromagnetic waves. If it is assumed that a change in the voltage is detected while the capacitor C (33) is charged, the power source voltage varies due to the change in the strength of the electric field of the received waves, and thus the charging voltage is not stable. For this reason, there is a possibility that errors might be included at the time of a measurement. Accordingly, in the present embodiment, the voltage at the time of discharging the capacitor C (33) is used, thereby enhancing the precision of the measurement.

(Example of Configuration of Voltage Doubler Rectifier Circuit 21)

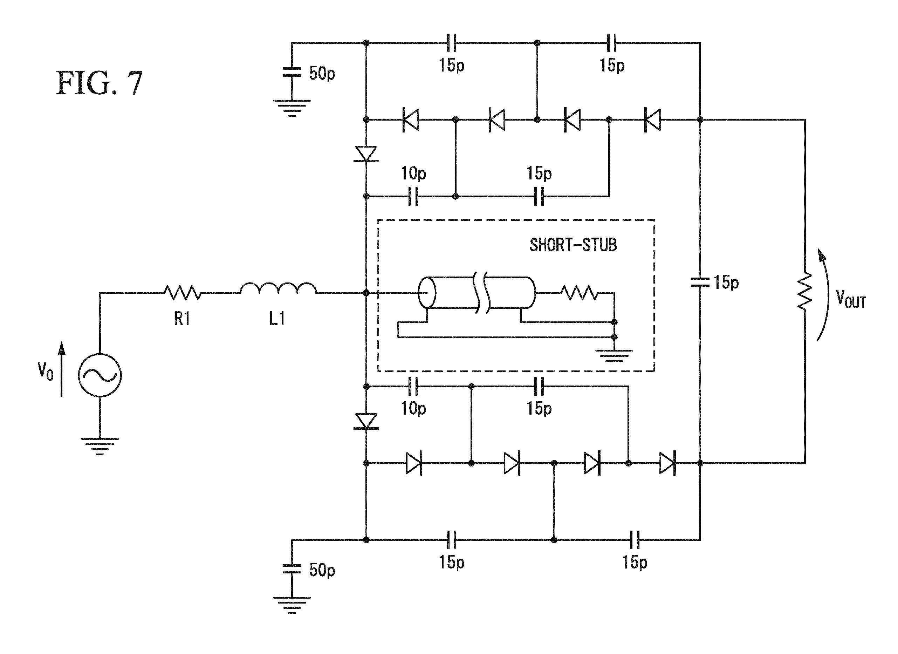

Hereinafter, an example of the configuration of the aforementioned voltage doubler rectifier circuit 21 is explained. FIG. 7 is a diagram illustrating an example of the configuration of the voltage doubler rectifier circuit 21. The voltage doubler rectifier circuit 21 shown in FIG. 7 has a well-known structure of a Cockcroft-Walton circuit (hereinafter, simply referred to as a "CW circuit") including a multistage boost rectifier circuit in which a diode and a capacitor are combined. This voltage doubler rectifier circuit 21 is an example of the symmetric three-stage CW circuit to which an input impedance of an antenna is connected. In FIG. 7, a short-stub is used for fitting the antenna to the circuit. The short-stub has a reactance value that is positive or negative according to the length thereof. For this reason, in actual use, the length of the short-stub is adjusted to maximize the voltage of the load. As the antenna, a half-wave dipole antenna or a meander antenna may be used.

(Temperature Measurement System Using Environmental Information Measurement Device of the Present Invention)

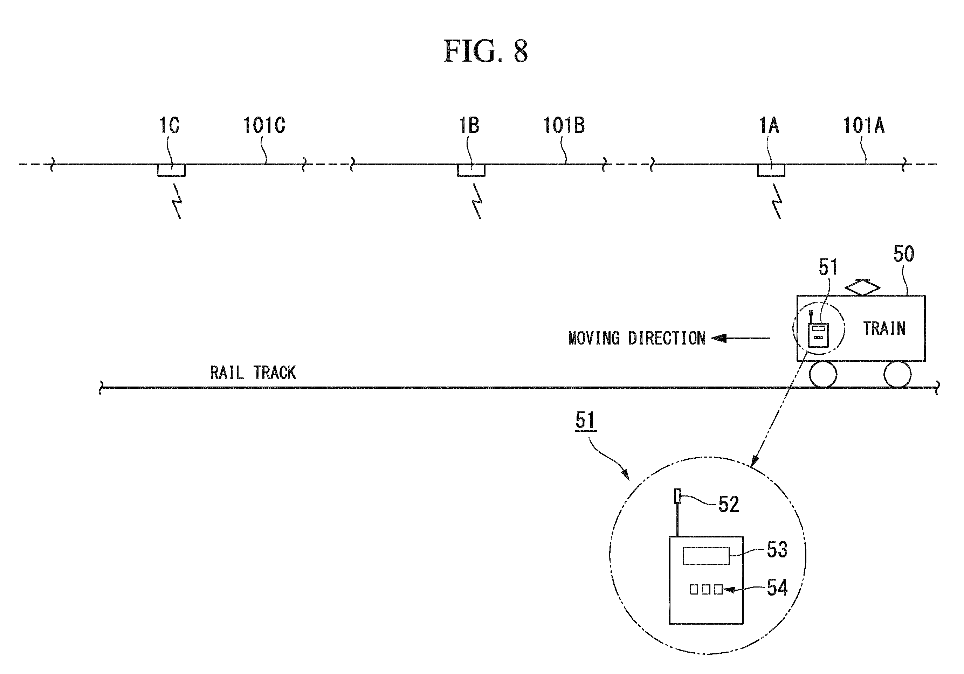

FIG. 8 is a diagram illustrating an example of a configuration of a temperature measurement system including the environmental information measurement device 1 and the environmental information collection device 51 of the present invention. FIG. 8 shows a case where the environmental information measurement devices 1 (1A, 1B, and 1C) are respectively attached onto temperature measurement target points (connecting points of the feeder cables) on multiple feeder cables 101 (101A, 101B, and 101C) connected in series along a rail track. The environmental information collection device (tag reader) 51 is installed in the electric train 50 traveling on the rail track. This environmental information collection device 51 has the function of the tag reader that communicates with the environmental information measurement device (RFID tag) 1, using wireless signals in the RFID system. The environmental information collection device 51 includes: an antenna 52; a display unit 53; and an operation switch group 54. The display unit 53 includes a liquid crystal display or the like. The operation switch group 54 includes a push-button switch or the like.

Each environmental information measurement device 1 (1A, 1B, and 1C) receives an electromagnetic wave of the wireless signal transmitted from the environmental information collection device 51 when the electric train 50 moves and comes close to the environmental information collection device 51. Then, the power source unit 20 of the environmental information measurement device 1 (1A, 1B, and 1C) having received the electromagnetic wave from the environmental information collection device 51 generates a power source (direct-current power source) from the power obtained from the received electromagnetic wave. Each environmental information measurement device 1 activates using the generated power source. Then, the activated environmental information measurement device 1 measures the temperature of the feeder cable 101, and transmits to the environmental information collection device 51, the measured temperature measurement data together with the identification ID information (identification information of the RFID).

In the case of FIG. 8, firstly, the environmental information collection device 51 comes close to the environmental information measurement device 1A, and thus receives temperature measurement data from the environmental information measurement device 1A. Then, the environmental information collection device 51 comes close to the environmental information measurement device 1B, and thus receives temperature measurement data from the environmental information measurement device 1B. Then, the environmental information collection device 51 comes close to the environmental information measurement device 1C, and thus receives temperature measurement data from the environmental information measurement device 1C.

Each time the environmental information collection device 51 receives temperature measurement data transmitted from each environmental information measurement device 1 (1A, 1B, and 1C), the environmental information collection device 51 displays the received temperature measurement data and related information (such as the identification information of the RFID) on the liquid crystal display of the display unit 53. The temperature measurement data is displayed as a table of figures, a graph, or the like. Then, it is determined whether or not the temperature at the temperature measurement target point is within a normal range. Based on a result of the determination, a warning signal is generated, which can be used as a countermeasure against abnormal situations. Additionally, each temperature measurement data received by the environmental information collection device 51 is stored as the temperature course data, together with the identification ID information of the environmental information measurement device 1 and the measurement date information.

Thus, in the temperature measurement system of the present invention, it is possible to automatically collect temperature measurement data from each environmental information measurement device 1 (1A, 1B, and 1C) only by causing the environmental information collection device 51 to come close to each environmental information measurement device 1 (1A, 1B, and 1C). For this reason, even when there are many temperature measurement target points, the states of the connecting points of the feeder cables 101 can be easily determined.

(Second Embodiment)

With reference to FIGS. 3A and 3B, a second embodiment is explained with respect to a case where the atmospheric pressure is detected as environmental information.

It has been explained in the first embodiment that the reference numeral 34 included in the detector 34 is the thermistor $R_{SM}$. However, by replacing the reference numeral 34 with a pressure sensor including a distortion gauge, a configuration that detects the atmospheric pressure can be made similar to the configuration of the first embodiment.

The distortion gauge (strain gauge) has a structure such that a thin resistor is formed over an elastic insulator. When the insulator is deformed, the resistor expands and contracts, and thus the resistance value of the resistor varies. The thermistor as a temperature sensor is replaced with that distortion gauge, thereby making it possible to measure a distortion, a displacement, and a load. Additionally, the distortion gauge is applicable to an atmospheric sensor.

In an atmospheric pressure sensor to which the distortion gauge is applied, a metal vacuum container contracts according to the amount of the atmospheric pressure, and the amount of that displacement is detected by the distortion gauge. The thermistor in the above temperature sensor circuit is replaced with that distortion gauge, thus implementing the atmospheric pressure sensor.

By such a configuration, it is possible to detect the atmospheric pressure.

Alternatively, one side electrode of the capacitor is configured to be displaced according to the atmospheric pressure, thereby making it possible to change the electrostatic capacitance of the capacitor according to the atmospheric pressure. Such a capacitor is applied to the capacitor 33 of the detector 35, thereby making it possible to measure the atmospheric pressure.

(Third Embodiment)

With reference to FIGS. 3A and 3B, a third embodiment is explained with respect to a case where the humidity is detected as environmental information.

It has been explained in the first embodiment that the reference numeral 33 included in the detector 35 is the capacitor C having the fixed electrostatic capacitance value, and the reference numeral 34 is the thermistor $R_{SM}$. However, by replacing the reference numeral 33 with a humidity sensor having a variable electrostatic capacitance, and replacing the reference numeral 34 with a pure electrical resistor, a configuration that detects the humidity can be made similar to the configuration of the first embodiment.

A humidity sensor has a structure of a capacitor including two electrodes sandwiching a dielectric substance whose electrostatic capacitance varies according to the humidity. The capacitor C and the thermistor $R_{SM}$ used in the temperature sensor circuit of the environmental information measurement device 1 are replaced respectively with that humidity sensor and a normal resistor, thereby enabling the environmental information measurement device 1 to detect the humidity. Macromolecular polymer is used as the dielectric substance forming the humidity sensor.

(Fourth Embodiment)

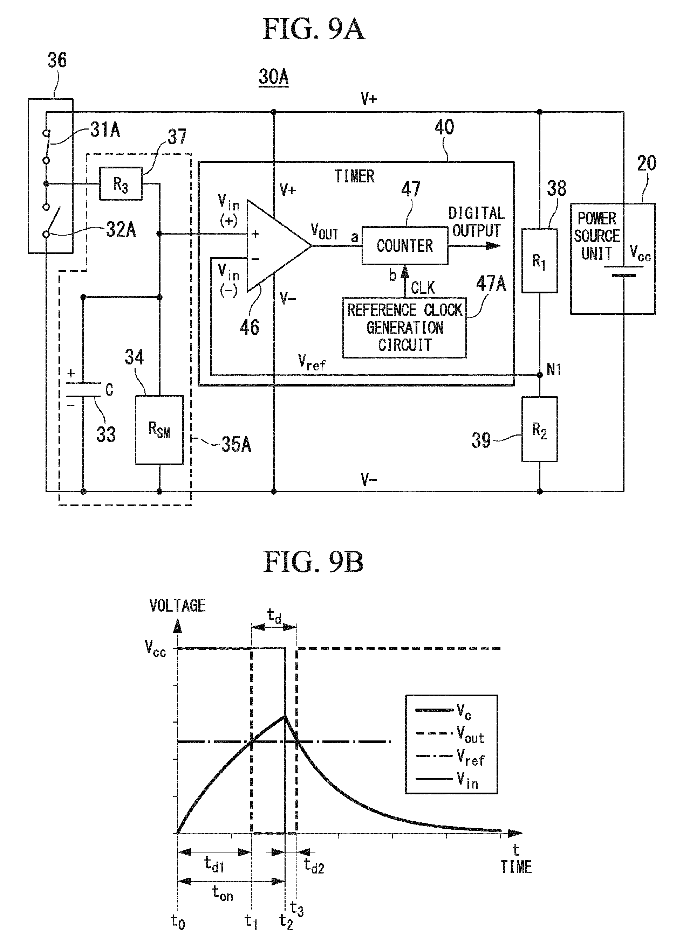

With reference to FIGS. 1 and 9A, a fourth embodiment is explained here with respect to a case where an environmental information measurer 30A having a configuration differing from that shown in FIG. 3A is applied.

In lieu of the environmental information measurer 30 shown in FIG. 1, the environmental information measure 30A shown in FIG. 9A is applied.

(Configuration and Operation of Environmental Information Measurer 30A)

Hereinafter, a configuration and operation of the environmental information measurer 30A are explained.

FIG. 9A is a diagram illustrating an example of a configuration of the environmental information measurer 30A. As shown in FIG. 9A, the environmental information measurer 30A includes: switches SW1 (31A) and SW2 (32A); the capacitor C (33) to be charged with the power source (voltage $V_{cc}$) generated by the power source unit 20; the thermistor $R_{SM}$ (34) that is a temperature sensor having a resistance value varying according to the temperature; a resistor $R_3$ (37); and

resistors $R_1$ (38) and $R_2$ (39) that voltage-divide the power source voltage.

A circuit network including the capacitor C (33), the thermistor $R_{SM}$ (34), and the resistor $R_3$ (37) constitutes a detector 35A.

The switches SW1 (31A) and SW2 (32A) constitute a switch unit 36. This switch unit 36 is actually a semiconductor switch including a MOS transistor, or the like. Alternatively, the switch unit 36 may be a CMOS digital circuit. For example, the CMOS digital circuit is an inverter circuit. Such the switch unit 36 is regarded as a switch that outputs a high-level signal or a low-level signal. In other words, the connected state and the disconnected state of the switches SW1 (31A) and SW2 (32A) have mutually complementary relationship. Therefore, the switch unit 36 outputs any one of the high-level signal and the low-level signal.

As shown in FIG. 9A, the switch unit 36 includes: an output terminal connected to the resistor $R_3$ (37); a power source terminal connected to the positive terminal of the power source unit (voltage $V_{cc}$) 20 via the power source line V+; and a ground terminal connected to the negative terminal of the power source unit (voltage $V_{cc}$) 20 via the power source line V-. One end of the resistance $R_3$ (37) is connected to the switch unit 36. The other end of the resistance $R_3$ (37) is connected to the positive terminal of the capacitor C (33) and the non-inverting input terminal $V_{in}(+)$ of the comparator 46. Additionally, one end of the thermistor $R_{SM}$ (34) that serves as a temperature sensor is connected to the non-inverting input terminal $V_{in}(+)$ of the comparator 46, and the other end thereof is connected to the negative terminal of the power source unit 20 via the power source line V-. Further, the negative terminal of the capacitor C (33) is connected to the negative terminal of the power source unit 20 via the power source line V-.

One end of the resistor $R_1$ (38) is connected to the power source line V+, and the other end thereof is connected to one end of the resistor $R_2$ (39) via the node N1. The other end of the resistor $R_2$ (39) is connected to the power source line V-. Accordingly, the node N1 is a point at which the output voltage $V_{cc}$ of the power source unit 20 is voltage-divided. Additionally, this node N1 is connected to the non-inverting input terminal $V_{in}(-)$ of the comparator 46. Further, the output side of the comparator 46 is connected to a timer control terminal a of the counter 47. Moreover, a clock input terminal b of the counter 47 is connected to an output terminal of the reference clock generation circuit 47A. The reference clock generation circuit 47A inputs a reference clock CLK to the clock input terminal b.

The switch unit 36 switches the voltage to be output to the output terminal, under control of the controller 2 (FIG. 1).

Hereinafter, the operation of the environmental information measurer 30A is explained with reference to FIGS. 9A and 9B.

FIG. 9B is a timing chart illustrating the operation of the environmental information measurer 30A. In FIG. 9B, a vertical axis denotes the voltage of each signal, and a horizontal axis denotes the time course. Regarding the signal waveform shown in FIG. 9B, $V_{in}$ denotes an input pulse that the switch unit 36 supplies to the detector 35A under control of the controller 2. $V_c$ denotes the voltage of the capacitor C (33). $V_{ref}$ denotes the reference voltage generated from the power source and the fixed resistances (resistors $R_1$ and $R_2$). $V_{out}$ denotes an output of the comparator 46. $t_{on}$ denotes a duration from the time when charging of the capacitor C (33) is initiated to the time t2, the input pulse being a high-level signal in the duration. Additionally, $t_d$ denotes a duration while the comparator outputs a low-level signal, that is, a duration satisfying that $V_c > V_{ref}$.

Regarding explanations of these drawings, it is assumed that the power source voltage $V_{cc}$ (charging initiation voltage) is in a state of being able to be supplied from the power source unit 20 to the environmental information measurer 30A, and that the capacitor C (33) is in a state of having been discharged.

In this initial state, under control of the controller 2, the switch unit 36 outputs a high-level signal. In other words, in the switch unit 36, the switch SW1 (31A) is closed, and the switch SW2 (32A) is opened, thereby initiating charging of the capacitor C (33) (a state at the time to shown in FIG. 9B).

By maintaining this charging state, electric charge is gradually stored in the capacitor C (33), and thus the charging proceeds via the resistor $R_3$ (37). The charged voltage of the capacitor C (33) gradually increases, and becomes identical to the reference voltage $V_{ref}$ at the time $t_1$. Then, when the charged voltage of the capacitor C (33) becomes equal to or higher than the reference voltage $V_{ref}$, the output signal $V_{out}$ of the comparator 46 inverts from an L state (voltage corresponding to the voltage V- of the power source supply to the comparator) to an H state (voltage corresponding to the voltage V+ of the power source supply to the comparator).

Then, under control of the controller 2, the switch unit 36 outputs a low-level signal (a state at the time $t_2$ shown in FIG. 9B). In other words, in the switch unit 36, the switch SW1 (31A) is opened, and the switch SW2 (32A) is closed, thereby discharging the electric charge stored in the capacitor C (33) via the thermistor $R_{SM}$ (34). The charged voltage of the capacitor C (33) gradually decreases, and becomes identical to the reference voltage $V_{ref}$ at the time $t_3$. Then, when the charged voltage of the capacitor C (33) becomes equal to or lower than the reference voltage $V_{ref}$, the output signal $V_{out}$ of the comparator 46 inverts from the H state (voltage corresponding to the voltage V+ of the power source supply to the comparator) to the L state (voltage corresponding to the voltage V- of the power source supply to the comparator).

In parallel to the above charging and discharging control, under control of the controller 2, the counter 47 counts the reference clock CLK output from the reference clock generation circuit 47A. The counter 47 counts: a duration $t_{d1}$ from the time (time to) when charging of the capacitor C (33) is initiated to the time $t_1$ when the output signal of the capacitor 46 transits from the H state to the L state; a duration $t_{on}$ from the time (time to) when charging of the capacitor C (33) is initiated to the time (time $t_2$) when discharging thereof is initiated; and a duration $t_{d2}$ from the time (time $t_2$) when discharging of the capacitor C (33) is initiated to the time $t_3$ when the output signal of the capacitor 46 transits from the L state to the H state.

Thus, according to the control of the controller 2 and the output state of the comparator 46, the environmental information measurer 30A counts the duration (the number of reference clocks) in which the output state of the comparator 46 indicates the L-state, thereby converting the temperature into time to make a measurement.

Thus, based on the detected temperature, the environmental information measurer 30A performs conversion into information indicating a time. The environmental information measurer 30A can use the converted information directly as a response signal from the RFID tag to the tag reader.

If it is assumed that the reference voltage is generated by the resistor voltage-dividing the power source voltage, a result of the determination by the comparator does not depend on a variation of the power source voltage. Here, LPV7215 (trademark) made by the National Semiconductor was used as the comparator 46 in this experimentation circuit. This comparator has the extremely small power consumption of 1.2 $\mu$W when the comparator is operated with the power source voltage of 2 V, thus contributing low power consumption of the environmental information measurer 30A.

(Operational Model of Detector)

Regarding the detector 35A, explanations of the response characteristics can be simplified if different operational models are used between charging and discharging of the capacitor C (33).

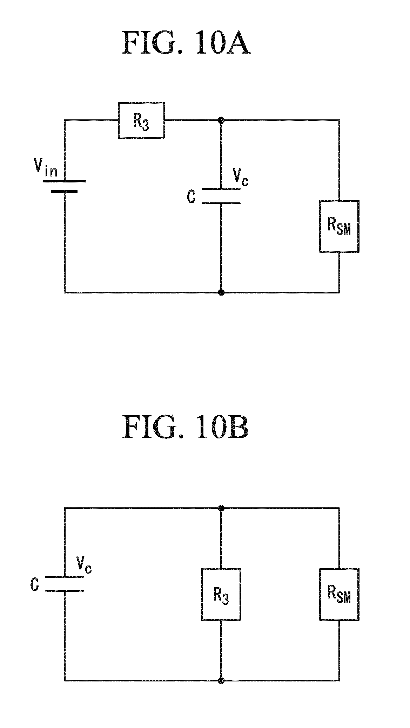

FIGS. 10A and 10B are diagrams illustrating the detector 35A where the detector 35A is denoted as an equivalent circuit. Firstly, the operational model of the detector 35A at the time of charging is explained here with reference to FIG. 10A. When the input signal (input pulse) supplied from the switch unit 36 is a high-level signal under the control of the controller 2, if this is assumed to be a power source, the circuit connected to the non-inverting input terminal of the comparator 46 can be converted into the circuit shown in FIG. 10A.

A transient response $V_c(t)$ of this equivalent circuit can be expressed as Formula (4).

[Formula 4]

$$V_c(t) = \frac{R_{SM}V_{high}}{R_3 + R_{SM}}\left\{1 - \exp\left(-\frac{R_3 + R_{SM}}{CR_3 R_{SM}}t\right)\right\} \tag{4}$$

By solving Formula (4), the duration $t_{d1}$ from the time when the input signal $V_{in}$ becomes a high level signal to the time when $V_c(t)=V_{ref}$.

[Formula 5]

$$t_{d1} = -\frac{CR_3 R_{SM}}{R_3 + R_{SM}}\ln\left(1 - \frac{R_3 + R_{SM}}{R_a V_{high}}V_{ref}\right) \tag{5}$$

Next, the operational model of the detector 35A at the time of discharging is explained with reference to FIG. 10B. When, under the control of the controller 2, the input signal (input pulse) supplied from the switch unit 36 is a low-level signal, if this is assumed to be grounded, the circuit connected to the non-inverting input terminal of the comparator 46 can be converted into the circuit shown in FIG. 10B.

A transient response $V_c(t)$ of this equivalent circuit can be expressed as Formula (6).

[Formula 6]

$$V_c(t) = V_c(t_{on})\exp\left(-\frac{R_3 + R_{SM}}{CR_3 R_{SM}}t\right) \tag{6}$$

At the start of discharging, the capacitor C is assumed to have been charged to the voltage indicated by $V_c$

($t_{on}$). Accordingly, by solving Formula (6), the duration $t_{d2}$ from the time when the input signal $V_{in}$ becomes a low level signal to the time when $V_c(t)$ decreases from the $V_c(t_{on})$ and becomes $V_c(t) = V_{ref}$ can be expressed as Formula (7).

[Formula 7]

$$t_{d2} = -\frac{CR_3 R_{SM}}{R_3 + R_{SM}} \ln \frac{V_{ref}}{V_c(t_{on})} \qquad (7)$$

As shown in FIG. 9B, the duration $t_d$ can be expressed as Formula (8).

[Formula 8]

$$t_d = t_{on} - t_{d1} + t_{d2} \qquad (8)$$

In other words, it is possible to calculate the theoretical value of the duration $t_d$ based on Formulas (5), (7), and (8).

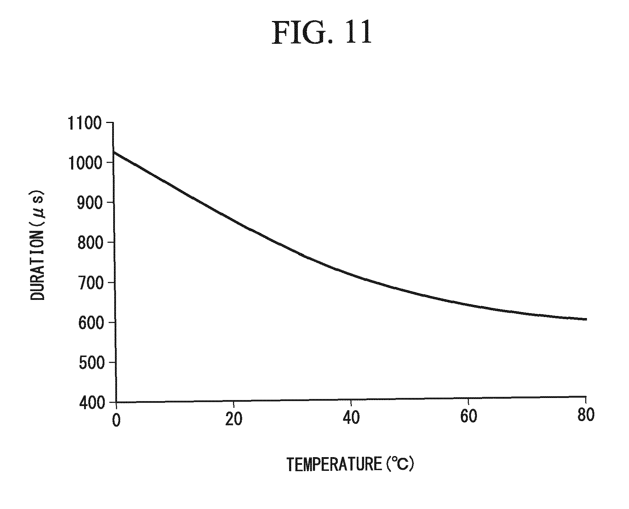

The theoretical value of the duration $t_d$ derived based on each of the above Formulas is explained here with reference to FIG. 11.

The duration $t_d$ per temperature was calculated from the temperature property of the thermistor used in this experimentation, using Formulas (5), (7), and (8). A result of the calculation per temperature is shown as a graph.

FIG. 11 is a graph illustrating the result of the calculation per temperature.

In FIG. 11, a vertical axis denotes the duration $t_d$, and a horizontal axis denotes the temperature.

As shown in this graph, the value of the duration $t_d$ monotonically decreases as the temperature increases, and the temperature has a one-on-one relationship with the value of the duration $t_d$.

The configuration of the environmental information measurer 30A shown in the fourth embodiment is modeled based on the equivalent circuits shown in FIGS. 10A and 10B, and the Formulas (4) to (8) based on that model, thereby making it possible to measure the temperature.

Next, to evaluate the validity of the above theoretical value, a result of comparison between the above theoretical value and the temperature actually measured using the environmental information measurer 30A is shown here.

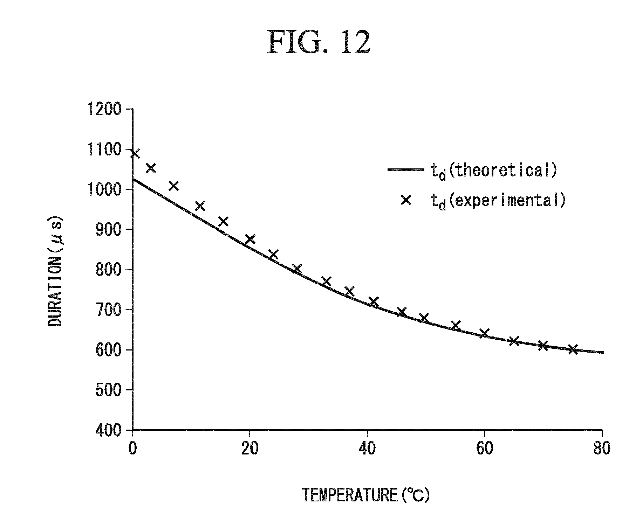

FIG. 12 is a graph illustrating a comparison between the theoretical values and the experimental values actually measured using the environmental information measurer 30A.

In FIG. 12, a vertical axis denotes the duration $t_d$, and a horizontal axis denotes the temperature.

It can be understood from the result shown in FIG. 12 that the experimental values of the measured temperature (indicated by the mark "x") substantially match the theoretical values (graph indicated by a solid line shown in FIG. 12), and thus it is possible to measure the temperature using the configuration of that environmental information measurer 30A.

In the configuration used for that evaluation, it is possible to reduce the power consumption to 8 W in total when the controller 2 and the environmental information measurer 30A are driven to measure the temperature.

Although the embodiments of the present invention have been explained, the correspondence relationship between the present invention and the above embodiments is explained here. In the above embodiments, an environmental information measurement device of the present invention corresponds to the environmental information measurement device 1. A communication unit of the present invention corresponds to the communication unit 10. A power source unit of the present invention corresponds to the power source unit 20. An environmental information detector of the present invention corresponds to the environmental information detectors 35 and 35A (including the thermistor $R_{SM}$ (34) and the capacitor C (33)). A timer of the present invention corresponds to the timer 40 (a portion including the comparator 46, the counter 47, and the like). A first switch of the present invention corresponds to the switch SW1 (31). A second switch of the present invention corresponds to the switch SW2 (32). Environmental information of the present invention corresponds to the temperature measurement data at the temperature measurement target points measured by the environmental information device 1.

(1) According to one embodiment of the present invention, the environmental information measurement device 1 includes: the power source unit 20; the environmental information detector 30; the timer (including the comparator 46, the counter 47, and the like) 40; and the controller 2. The power source unit 20 generates, from an electromagnetic wave received, a power source voltage to be supplied to a load. The load includes the environmental information detector 30, the timer 40, and the controller 2. The environmental information detector 30 includes the detector 35 including a circuit element having an impedance or an electrostatic capacitance that varies according to a physical amount detected under an environment at a measurement target point. The environmental information detector 30 outputs a signal that varies according to a response characteristic of the detector 35. The timer 40 measures a duration from the time when a measurement is initiated to the time when a voltage of the output signal becomes a predetermined detection voltage.

Based on the measured duration, the timer 40 generates environmental information according to the physical amount. The controller 2 controls an operation of the environmental information detector 30.

Thus, using a simple circuit configuration with low power consumption, it is possible to easily measure environmental information at the measurement target points, such as the temperature (the temperature of the connecting points of feeder cables on power transmission lines, power distribution lines, or electric train lines in the power system), the humidity, or the atmospheric pressure.

(2) The environmental information measurement device 1 according to the above embodiment further includes the communication unit 10 that transmits, according to a request, the measurement data generated according to the environment.

In the environmental information measurement device 1 having such a configuration, the communication unit 10 transmits to an external device (such as an environmental information collection device), the measurement data generated based on the environmental information measured by the environmental information detector 30 (more accurately, for example, temperature measurement data measured by converting the temperature into time to make a measurement).

Thus, using a simple circuit configuration with low power consumption, it is possible to easily measure environmental information at the measurement target points, such as the temperature (the temperature of the connecting points of feeder cables on power transmission lines, power distribution lines, or electric train lines in the power system), the humidity, or the atmospheric pressure. In addition to this effect, it is possible to easily and automatically perform a measurement (collect measurement data) even when there are many measurement target points.

(3) The environmental information measurement device according to the above embodiment, the detector 35 includes a capacitor. The controller 2 controls, according to the power source voltage, charging of the capacitor included in the detector 35 and a measurement of the duration by the timer 40.

In the environmental information measurement device 1 having such a configuration, the controller 2 performs charging of the capacitor (capacitor C) included in the detector 35 when the power source voltage becomes a predetermined voltage (charging initiation voltage). Then, the controller 2 initiates discharging of the capacitor (capacitor C) included in the detector 35. The timer 40 measures a duration for the charged voltage of the capacitor (capacitor C) included in the detector 35 to be lowered to the predetermined reference voltage $V_{ref}$.

Thus, it is possible to convert the environmental information at the measurement target point into a time to make a measurement, using the CR discharging circuit. For this reason, it is possible to measure the temperature, using a simple circuit with lower power consumption.

(4) The environmental information measurement device 1 according to the above embodiment, the controller 2 initiates charging of the capacitor (capacitor C) when the power source voltage becomes a predetermined charging initiation voltage.

In the environmental information measurement device 1 having such a configuration, charging of the capacitor (capacitor C) included in the detector 35 is performed when the power source voltage generated by the power source unit 20 becomes the predetermined charging initiation voltage. Then, discharging of the capacitor (capacitor C) included in the detector 35 is initiated.

Thus, it is possible to convert the environmental information at the measurement target point into a time to make a measurement, using the CR discharging circuit. For this reason, it is possible to measure the temperature, using a simple circuit with lower power consumption.

(5) In the above embodiment, the timer 40 measures a duration from the time when discharging of the capacitor (capacitor C) included in the detector 35 is initiated to the time when the voltage of the signal is lowered to the detection voltage.

In the environmental information measurement device 1 having such a configuration, charging of the capacitor (capacitor C) included in the detector is performed when the power source voltage generated by the power source unit 20 becomes the predetermined charging initiation voltage. Then, discharging of the capacitor (capacitor C) included in the detector is initiated. The timer 40 measures a duration for the charged voltage of the environmental information (capacitor C) to be lowered to the predetermined reference voltage $V_{ref}$.

Thus, it is possible to convert the environmental information at the measurement target point into a time to make a measurement, using the CR discharging circuit. For this reason, it is possible to measure the temperature, using a simple circuit with lower power consumption.

(6) In the above embodiment, the environmental information detector 30 includes: the switch SW1 (31) that blocks charging of the capacitor (capacitor C) included in the detector; and the switch SW 2 (32) that blocks discharging of the capacitor (capacitor C) included in the detector. When the capacitor (capacitor C) is charged, the controller 2 controls the switch SW1 (31) to be in the connected state to perform charging from the power source unit 20 to the capacitor (capacitor C), and controls the switch SW2 (32) to be in the disconnected state to terminate discharging of the capacitor. When the capacitor (capacitor C) is discharged, the controller 2 controls the switch SW1 (31) to be in the disconnected state to terminate charging from the power source unit 20 to the capacitor (capacitor C), and controls the switch SW2 (32) to be in the connected state to perform discharging of the capacitor (capacitor C).

In the environmental information measurement device 1 having such a configuration, for example, when the capacitor (capacitor C) is charged by the power source unit 20, the switch SW1 (31) connects the power source unit 20 to the capacitor (capacitor C), and the switch SW2 (32) disconnects the capacitor (capacitor C) from the temperature detector (thermistor $R_{SM}$). When the capacitor (capacitor C) is discharged, the switch SW1 (31) disconnects the power source unit 20 from the capacitor (capacitor C), and the switch SW2 (32) connects the capacitor (capacitor C) to the temperature detector (thermistor $R_{SM}$).

Thus, the controller 2 controls the switches SW1 (31) and SW2 (32), thereby making it possible to easily perform the charging of the capacitor (capacitor C) and the discharging by the temperature detector (thermistor $R_{SM}$). For this reason, it is possible to convert the environmental information at the measurement target point into a time to make a measurement, using a simple circuit configuration with low power consumption.

(7) In the above embodiment, the connected state and the disconnected state of the switch SW1 (31) and SW2 (32) have a mutually complementary relationship between the switch SW1 (31) and SW2 (32).

In the environmental information measurement device 1 having such a configuration, the switches SW1 (31) and SW2 (32) are combined to constitute an SPDT (single pole double throw) switch. As explained in the present embodiment, the switches SW1 (31) and SW2 (32) function as the SPDT switch, which can select and output any one of the power source voltage and the reference voltage. Thanks to such a switch, switching to a digital circuit element having a CMOS structure (semiconductor device) is enabled.

Thus, the controller 2 controls the switches SW1 (31) and SW2 (32), thereby making it possible to easily perform the charging of the capacitor (capacitor C) and the discharging by the temperature detector (thermistor $R_{SM}$). For this reason, it is possible to more simplify the configurations of the switches SW1 (31) and SW2 (32), and convert the environmental information at the measurement target point into a time to make a measurement, using a simple circuit configuration with low power consumption.

(8) In the above embodiment, when charging of the capacitor (capacitor C) is performed before discharging of the capacitor included in the detector 35 is initiated, the timer 40 measures a duration from the time when the voltage of the signal becomes the detection voltage to the time when the charging is terminated.

In the environmental information measurement device 1 having such a configuration, the measuring time can be made longer, thereby making it possible to increase the detection precision while simplifying the configuration.

(9) In the above embodiment, the physical amount includes any one of the temperature, the atmospheric pressure, and the humidity. The environmental information detector 30 detects the physical amount using a circuit element included in the detector 35.

In the environmental information measurement device 1 having such a configuration, the environmental information detector 30 can be configured to detect any one of the temperature, the atmospheric pressure, and the humidity, according to the circuit element included in the detector 35. In this case, for example, the temperature detector (thermistor $R_{SM}$) is provided, thereby enabling a detection of the temperature. The humidity detector is provided, thereby enabling a detection of the humidity. The atmospheric pressure detector is provided, thereby enabling a detection of the atmospheric pressure.

Thus, it is possible to convert the environmental information at the measurement target point into a time to make a measurement, using a simple circuit configuration with low power consumption.

(10) In the above embodiment, the environmental information detector 30 is provided so as to be thermally connected to an electric cable that is a temperature measurement target.

In the environmental information measurement device 1 having such a configuration, the temperature detector (thermistor $R_{SM}$) is placed so as to contact a surface of the temperature measurement target point. In this case, in order to enhance the thermal connection (thermal conductivity) and the electric insulation between the temperature detector (thermistor $R_{SM}$) and the temperature measurement target point, these elements are in contact with each other via a silicon rubber compound or the like.

Thus, it is possible to precisely measure the temperature at the temperature measurement target point.

(11) In the above embodiment, an environmental information measurement system includes: the aforementioned environmental information measurement device which transmits information measured based on the detected environmental information; and an environmental information collection device which collects the information transmitted.

In the environmental information measurement system having such a configuration, the environmental information collection device 51 stores and collects the measurement data transmitted from the environmental information measurement device 1.

Thus, using a simple circuit configuration with low power consumption, it is possible to easily measure the temperature of an object to be measured, such as the temperature of feeder cables on power transmission lines, power distribution lines, or electric train lines in the power system. Additionally, it is possible to easily and automatically collect temperature data even when there are many measurement target points. Further, such a temperature measurement method is applicable to collection of environmental information such as the temperature.

Although the embodiments of the present invention have been explained, the aforementioned environmental

EP 2 618 112 A1

information measurement device 1 uses the RFID tag and includes a computer system. The aforementioned process steps of each unit are stored as a program in a computer-readable recording medium (such as a ROM). A computer reads and executes the program, thereby executing the above processes.

Although the embodiments of the present invention have been explained, the environmental information measurement device and the environmental information measurement system are not limited to the above illustrated examples, various modifications may be made without departing from the scope of the present invention.

For example, the aspects of the embodiments 2 and 3 may be applied to the aspect of the embodiment 4. Thus, it is possible to perform various environmental information measurements without limiting the present invention to the case where the temperature is targeted for the measurement.

Additionally, in the environmental information measurement having the configuration shown in the above embodiment, it can be assumed that deviation due to the configuration of the environmental information measurement device occurs. If the deviation occurring depending on the configuration of the environmental information measurement device is previously specified, it is possible to correct that deviation information. The environmental information collection device previously stores that deviation information in the storing unit included in the environmental information collection device. Then, the environmental information collection device refers to the deviation information stored in the storing unit, according to a result of the measurement notified from the environmental information measurement device, thereby collecting the result of the measurement notified from the environmental information measurement device.

INDUSTRIAL APPLICABILITY

The present invention is applicable to a device, a system, a method, and the like, for managing environmental information, such as the temperature, the humidity, or the atmospheric pressure at connecting points of power transmission lines, power distribution lines, feeder cables, and the like.

DESCRIPTION OF REFERENCE NUMERALS

| | |
|---|---|
| 1: | environmental information measurement device |
| 2: | controller |
| 3: | storing unit |
| 10: | communication unit |
| 11: | receiver |
| 12: | transmitter |
| 13: | antenna |
| 20: | power source unit |
| 21: | voltage doubler rectifier circuit |
| 22: | charging controller |
| 22A: | power source voltage detector |
| 30, 30A: | environmental information measurer |
| 31: | switch SW1 |
| 32: | switch SW2 |
| 33: | capacitor C |
| 34: | thermistor $R_{SM}$ |
| 35, 35A: | detector |
| 36, 37, 38: | resistor |
| 40: | timer |
| 46: | comparator |
| 47: | counter |
| 47A: | reference clock generation circuit |
| 50: | electric train |
| 51: | environmental information collection device (tag reader) |
| 52: | antenna |
| 53: | display unit |
| 54: | operation switch group |
| 100: | electric train line |

(continued)

| | |
|---|---|
| 101: | feeder cable |
| 101a: | connecting point of feeder cable (crimping sleeve) |
| 102: | trolley line |
| 107a: | feeder branch |
| 108a: | clamp |

**Claims**

1. An environmental information measurement device comprising:

   a power source unit configured to generate, from an electromagnetic wave received, a power source voltage to be supplied to a load;
   an environmental information detector including a detector including a circuit element having an impedance or an electrostatic capacitance that varies according to a physical amount detected under an environment at a measurement target point, the environmental information detector being configured to output a signal that varies according to a response characteristic of the detector;
   a timer configured to measure a duration from the time when measurement is initiated to the time when a voltage of the signal becomes a predetermined detection voltage; and
   a controller configured to control an operation of the environmental information detector,
   wherein the load includes the environmental information detector, the timer, and the controller.

2. The environmental information measurement device according to claim 1, further comprising:

   a communication unit configured to transmit the environmental information according to a request.

3. The environmental information measurement device according to claim 1 or 2, wherein the detector includes a capacitor, and
   the controller is configured to control, according to the power source voltage, charging of the capacitor and measurement of the duration by the timer.

4. The environmental information measurement device according to claim 3, wherein the controller is configured to initiate charging of the capacitor when the power source voltage becomes a predetermined charging initiation voltage.

5. The environmental information measurement device according to claim 3 or 4, wherein the timer is configured to measure a duration from the time when discharging of the capacitor is initiated to the time when the voltage of the signal is lowered to the detection voltage.

6. The environmental information measurement device according to any one of claims 3 to 5, wherein the environmental information detector comprises:

   a first switch configured to block charging from the power source unit to the capacitor; and
   a second switch configured to block discharging of the capacitor,
   wherein the controller is configured to, when the capacitor is charged, control the first switch to be in a connected state to perform charging from the power source unit to the capacitor, and control the second switch to be in a disconnected state to terminate discharging of the capacitor, and
   the controller is configured to, when the capacitor is discharged, control the first switch to be in a disconnected state to terminate charging from the power source unit to the capacitor, and control the second switch to be in a connected state to perform discharging of the capacitor.

7. The environmental information measurement device according to claim 6, wherein the first switch is in the connected state when the second switch is in the disconnected state, and
   the first switch is in the disconnected state when the second switch is in the connected state.

8. The environmental information measurement device according to any one of claims 3 to 7, wherein the timer is configured to, when charging of the capacitor is performed before discharging of the capacitor is initiated, measure a duration from the time when the voltage of the signal becomes the detection voltage to the time when the charging is terminated.

9. The environmental information measurement device according to any one of claims 1 to 8, wherein the physical amount includes any one of a temperature, an atmospheric pressure, and a humidity, and
the environmental information detector is configured to detect the physical amount from a circuit element included in the detector.

10. The environmental information measurement device according to any one of claims 1 to 9, wherein the environmental information detector is configured to be thermally connected to an electric cable having a temperature to be measured.

11. An environmental information measurement system comprising:

the environmental information measurement device according to any one of claims 1 to 10 which is configured to transmit information measured based on the environmental information; and
an environmental information collection device configured to collect the information transmitted.

12. An environmental information measurement method comprising steps of:

generating from an electromagnetic wave received, a power source voltage to be supplied to a load;
outputting a signal that varies according to a response characteristic of a circuit network including a circuit element having an impedance or an electrostatic capacitance that varies according to a physical amount detected under an environment at a measurement target point;
measuring a duration from the time when measurement is initiated to the time when a voltage of the signal becomes a predetermined detection voltage; and
generating environmental information according to the physical amount,
wherein the step of outputting the signal, the step of measuring the duration, and the step of generating the environmental information are performed using the power source voltage.

FIG. 1

# FIG. 2

FIG. 2

FIG. 3A

FIG. 3B

$$\gamma = \frac{R_2}{R_1 + R_2}$$

$$V_{ref} = \gamma \cdot V_{cc}$$

# FIG. 4

51

ENVIRONMENTAL
INFORMATION COLLECTION DEVICE
(TAG READER)

1

ENVIRONMETNAL INFORMATION
MESUREMENT DEVICE
(RFID TAG)

TRANSMIT
ELECTROMAGNETIC
WAVES
S11

RECEIVE
ELECTROMAGNETIC WAVES
(GENERATE POWER SOURCE)
S21

DETECT POWER
SOURCE VOLTAGE
(DETECT RECEPTION)
(DETECT CHARGING
INITIATION VOLTAGE)
S22

INITIATE CHARGING
CLOSE SW1
OPEN SW2
S23

INITIATE DISCHARGING
OPEN SW1
CLOSE SW2
S24

COUNTER OPERATION
S25

S26
COMPARATOR
OPERATION
No

Yes

S12

RECEIVE TEMPERATURE
MEASUERMENT DATA

S27
TRANSMIT TEMPERATURE
MEASUERMENT DATA

STORE TEMPERATURE
MEASUERMENT DATA
S13

23

FIG. 5A

FIG. 5B

FIG. 6

FIG. 7

# FIG. 8

EP 2 618 112 A1

# FIG. 9A

# FIG. 9B

# FIG. 10A

# FIG. 10B

# FIG. 11

# FIG. 12

## INTERNATIONAL SEARCH REPORT

| | International application No. |
|---|---|
| | PCT/JP2011/071099 |

**A. CLASSIFICATION OF SUBJECT MATTER**
*G01D21/00*(2006.01)i, *G01K1/02*(2006.01)i, *G08C15/00*(2006.01)i, *G08C17/00*(2006.01)i, *H04Q9/00*(2006.01)i

According to International Patent Classification (IPC) or to both national classification and IPC

**B. FIELDS SEARCHED**

Minimum documentation searched (classification system followed by classification symbols)
G01D21/00, B60M1/28, G01K1/02, G08C15/00, G08C17/00, H04Q9/00

Documentation searched other than minimum documentation to the extent that such documents are included in the fields searched
Jitsuyo Shinan Koho        1922-1996   Jitsuyo Shinan Toroku Koho   1996-2011
Kokai Jitsuyo Shinan Koho  1971-2011   Toroku Jitsuyo Shinan Koho   1994-2011

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2004-34931 A (East Japan Railway Co.), 05 February 2004 (05.02.2004), paragraphs [0014] to [0037]; fig. 1 to 9 (Family: none) | 1-12 |
| Y | JP 2005-24441 A (NTN Corp.), 27 January 2005 (27.01.2005), paragraph [0019]; fig. 2 & EP 1615091 A1          & KR 10-2005-0110632 A & US 2006/0170551 A1      & WO 2004/072747 A1 | 1-12 |
| Y | JP 2005-106555 A (Sanyo Electric Co., Ltd.), 21 April 2005 (21.04.2005), paragraph [0016]; fig. 1 & CN 1602798 A            & KR 10-2005-0031433 A & TW 278303 B             & US 2005/0147151 A1 | 1-12 |

| [X] Further documents are listed in the continuation of Box C. | [ ] See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 07 December, 2011 (07.12.11) | 20 December, 2011 (20.12.11) |

| Name and mailing address of the ISA/ Japanese Patent Office | Authorized officer |
|---|---|
| Facsimile No. | Telephone No. |

Form PCT/ISA/210 (second sheet) (July 2009)

**INTERNATIONAL SEARCH REPORT**

International application No.

PCT/JP2011/071099

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2006-162572 A  (Asahi Kasei Microsystems Co., Ltd.), 22 June 2006 (22.06.2006), paragraphs [0031] to [0041]; fig. 1 to 5 (Family: none) | 1-12 |
| Y | JP 9-62808 A  (Mitsubishi Electric Corp.), 07 March 1997 (07.03.1997), claims 1 to 5; paragraph [0008] & DE 69532637 D       & EP 1286301 A1 & US 5736728 A | 3-11 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010208452 A

- JP 3966779 B

**Non-patent literature cited in the description**

- Near-infrared to infrared camera/ image measurement device. Hamazaki Photonics Corporation, 28 July 2010